(19) **Europäisches Patentamt / European Patent Office / Office européen des brevets**

(11) **EP 3 158 677 B1**

(12) # EUROPEAN PATENT SPECIFICATION

(45) Date of publication and mention
of the grant of the patent:
**12.09.2018 Bulletin 2018/37**

(51) Int Cl.:
*H04L 7/00* (2006.01)    *G11B 20/10* (2006.01)
*H03L 7/087* (2006.01)    *H04B 10/61* (2013.01)

(21) Application number: **14747327.6**

(86) International application number:
**PCT/EP2014/065665**

(22) Date of filing: **22.07.2014**

(87) International publication number:
**WO 2016/012035 (28.01.2016 Gazette 2016/04)**

(54) **AN APPARATUS FOR SYNCHRONIZING A SAMPLING SIGNAL ON A COMMUNICATION SIGNAL**

VORRICHTUNG ZUM SYNCHRONISIEREN EINES ABTASTSIGNALS AUF EINEM KOMMUNIKATIONSSIGNAL

APPAREIL DE SYNCHRONISATION D'UN SIGNAL D'ÉCHANTILLONNAGE SUR UN SIGNAL DE COMMUNICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**26.04.2017 Bulletin 2017/17**

(73) Proprietor: **Huawei Technologies Co., Ltd.**
**Longgang District**
**Shenzhen, Guangdong 518129 (CN)**

(72) Inventor: **STOJANOVIC, Nebojsa**
**80992 Munich (DE)**

(74) Representative: **Gill Jennings & Every LLP**
**The Broadgate Tower**
**20 Primrose Street**
**London EC2A 2ES (GB)**

(56) References cited:
EP-A2- 0 926 857      US-A- 5 309 482
US-A- 5 872 818

• STOJANOVIC NEBOJSA ET AL: "Chromatic dispersion estimation method for nyquist and faster than Nyquist coherent optical systems", OFC 2014, OSA, 9 March 2014 (2014-03-09), pages 1-3, XP032632943, DOI: 10.1109/OFC.2014.6886697 [retrieved on 2014-08-27]
• STOJANOVIC NEBOJSA ET AL: "A circuit enabling clock extraction in coherent receivers", 2012 38TH EUROPEAN CONFERENCE AND EXHIBITION ON OPTICAL COMMUNICATIONS, OSA, 16 September 2012 (2012-09-16), pages 1-3, XP032543948, [retrieved on 2014-01-08]
• ROO P ET AL: "Analog timing recovery architectures for PRML detectors", GLOBAL TELECOMMUNICATIONS CONFERENCE, 1995. CONFERENCE RECORD. COMMUNI CATION THEORY MINI-CONFERENCE, GLOBECOM '95., IEEE SINGAPORE 13-17 NOV. 1995, NEW YORK, NY, USA,IEEE, US, vol. 1, 13 November 1995 (1995-11-13), pages 571-576, XP010607621, DOI: 10.1109/GLOCOM.1995.501993 ISBN: 978-0-7803-2509-8

**Description**

TECHNICAL FIELD

The invention relates to the field of synchronization in communication receivers, in particular in optical communication receivers.

BACKGROUND OF THE INVENTION

The synchronization between a communication transmitter and a communication receiver is an important topic for reception and demodulation of communication signals transmitted over a communication channel.

The synchronization is usually performed by the communication receiver upon the basis of the received communication signal. The synchronization can in particular relate to synchronizing sampling time instants of a sampler of the communication receiver onto communication symbols of the received communication signal. This kind of synchronization is often referred to as timing recovery.

For synchronization, a phase-locked loop in the communication receiver can be employed. The phase-locked loop can comprise a phase detector for detecting a phase delay between the communication symbols and the sampling time instants. The phase-locked loop can then adapt the sampling time instants upon the basis of the detected phase delay. Common phase detectors comprise a Mueller and Muller phase detector, an Alexander phase detector, or a Gardner phase detector.

In case of a dispersive communication channel between the communication transmitter and the communication receiver, the received communication signal can suffer from dispersion and/or distortion. Common approaches for synchronization, however, show a limited synchronization performance in such scenarios.

In US 8,466,713 B2, a phase detection approach for synchronization is described. Two phase detectors are used which operate on rising and falling edges of communication symbols. US 5872818 A describes a symbol timing recovery apparatus.

SUMMARY OF THE INVENTION

It is the object of the invention to provide an apparatus for synchronizing a sampling signal on a communication signal. The apparatus can allow for an efficient synchronization in case of dispersive communication channels.

This object is achieved by the features of the independent claims. Further implementation forms are apparent from the dependent claims, the description and the figures.

The invention is based on the finding that a filter, e.g. a digital filter, having a plurality of filtering transfer functions, can be employed for filtering a sampled communication signal within a phase-locked loop. The plurality of filtering transfer functions of the filter can be used for successively filtering the sampled communication signal. A determiner can determine a plurality of synchronicity measures, wherein each synchronicity measure corresponds to a filtering transfer function of the filter. A selector can then select a filtering transfer function for further operation upon the basis of the plurality of synchronicity measures.

According to a first aspect, the invention relates to an apparatus for synchronizing a sampling signal on a communication signal, the communication signal comprising communication symbols, the sampling signal indicating sampling time instants of the communication signal, the apparatus comprising a sampler being configured to sample the communication signal at the sampling time instants indicated by the sampling signal to obtain a sampled communication signal, a filter being configured to filter the sampled communication signal using a first filtering transfer function to obtain a first filtered sampled communication signal, and to filter the sampled communication signal using a second filtering transfer function to obtain a second filtered sampled communication signal, a phase detector being configured to determine a first phase detection signal upon the basis of the first filtered sampled communication signal, and to determine a second phase detection signal upon the basis of the second filtered sampled communication signal, the first phase detection signal indicating a position of a sampling time instant within a communication symbol of the first filtered sampled communication signal, the second phase detection signal indicating a position of a sampling time instant within a communication symbol of the second filtered sampled communication signal, a determiner being configured to determine a first synchronicity measure upon the basis of the first phase detection signal, and to determine a second synchronicity measure upon the basis of the second phase detection signal, the first synchronicity measure and the second synchronicity measure indicating a synchronicity between the sampling signal and the communication signal, a selector being configured to select the first filtering transfer function or the second filtering transfer function of the filter for filtering the sampled communication signal upon the basis of the first synchronicity measure and the second synchronicity measure for synchronizing the sampling signal on the communication signal, and a sampling signal generator being configured to generate the sampling signal upon the basis of the first phase detection signal, or to generate the sampling signal upon the basis of the second phase detection signal. Thus, an efficient synchronization between the sampling signal and the communication signal can be realized.

The apparatus can be part of a communication receiver or can form a communication receiver. The communication receiver can be an optical communication receiver.

The sampler can be an analog-digital-converter (ADC). The filter can be a digital filter, e.g. a digital finite impulse response (FIR) filter. The first filtering transfer function and the second filtering transfer function of the filter can be determined by filter coefficients. The phase detector can be an analog or a digital phase detector. The determiner can determine the first synchronicity measure and the second synchronicity measure upon the basis of a standard deviation and/or a mean deviation of sampling time instants within communication symbols. The selector can select the first filtering transfer function or the second filtering transfer function being associated to an optimum, e.g. minimum, synchronicity measure.

In a first implementation form of the apparatus according to the first aspect as such, the apparatus further comprises a delayer being configured to delay the sampled communication signal in time domain by a predetermined time delay to obtain a delayed sampled communication signal, a further filter being configured to filter the delayed sampled communication signal using the first filtering transfer function to obtain a third filtered sampled communication signal, and to filter the delayed sampled communication signal using the second filtering transfer function to obtain a fourth filtered sampled communication signal, and a further phase detector being configured to determine a third phase detection signal upon the basis of the third filtered sampled communication signal, and to determine a fourth phase detection signal upon the basis of the fourth filtered sampled communication signal, the third phase detection signal indicating a position of a sampling time instant within a communication symbol of the third filtered sampled communication signal, the fourth phase detection signal indicating a position of a sampling time instant within a communication symbol of the fourth filtered sampled communication signal, wherein the determiner is further configured to determine the first synchronicity measure upon the basis of the third phase detection signal, and to determine the second synchronicity measure upon the basis of the fourth phase detection signal. Thus, the first synchronicity measure and the second synchronicity measure can be determined efficiently.

The delayer can be a digital filter, e.g. a digital FIR filter. The predetermined time delay can be a fraction of a communication symbol time, e.g. an eighth of a communication symbol time. The further filter can be a digital filter, e.g. a digital FIR filter. The first filtering transfer function and the second filtering transfer function of the further filter can be determined by further filter coefficients. The further phase detector can be an analog or a digital phase detector.

In a second implementation form of the apparatus according to the first implementation form of the first aspect, the delayer comprises an interpolation filter being configured to interpolate the sampled communication signal in time domain to obtain the delayed sampled communication signal. Thus, the delayed sampled communication signal can be determined efficiently.

The interpolation filter can interpolate the sampled communication signal by a predetermined interpolation factor. The predetermined interpolation factor can e.g. be 2, 4, or 8.

In a third implementation form of the apparatus according to the first implementation form or the second implementation form of the first aspect, the apparatus further comprises a weighter being configured to weight the third phase detection signal or the fourth phase detection signal by a predetermined weighting factor. Thus, an influence of the further filter and/or the further phase detector on the first synchronicity measure and the second synchronicity measure can be adapted.

The predetermined weighting factor can depend on the predetermined time delay of the delayer. The predetermined weighting factor can be a real number, e.g. 0.92.

In a fourth implementation form of the apparatus according to the first implementation form to the third implementation form of the first aspect, the determiner is configured to determine the first synchronicity measure or the second synchronicity measure according to the following equation:

$$CTQP = \sqrt{\overline{(A - \overline{A})^2}} \,/\, \overline{B}$$

wherein CTQP denotes the first synchronicity measure with A denoting the first phase detection signal, B denoting the third phase detection signal, $\overline{A}$ denoting a mean value of the first phase detection signal, and $\overline{B}$ denoting a mean value of the third phase detection signal, or wherein CTQP denotes the second synchronicity measure with A denoting the second phase detection signal, B denoting the fourth phase detection signal, $\overline{A}$ denoting a mean value of the second phase detection signal, and $\overline{B}$ denoting a mean value of the fourth phase detection signal. Thus, the first synchronicity measure or the second synchronicity measure can be determined efficiently.

In a fifth implementation form of the apparatus according to the first implementation form to the fourth implementation form of the first aspect, the determiner is further configured to determine a phase detector gain factor upon the basis of the third phase detection signal or the fourth phase detection signal, the phase detector gain factor indicating a magnitude of the first phase detection signal or the second phase detection signal in dependence of a position of a sampling time instant within a communication symbol of the first filtered sampled communication signal or the second filtered sampled communication signal. Thus, characteristics of the phase detector and/or the further phase detector can be determined efficiently.

The phase detector gain factor can relate to a slope of a timing error detector characteristic (TEDC) of the phase detector at a sampling time instant of zero.

In a sixth implementation form of the apparatus according to the fifth implementation form of the first aspect, the determiner is configured to determine the phase detector gain factor upon the basis of the third phase detection signal or the fourth phase detection signal according to the following equation:

$$K_{pd} = \overline{B}$$

wherein $K_{pd}$ denotes the phase detector gain factor, and $\overline{B}$ denotes a mean value of the third phase detection signal or the fourth phase detection signal. Thus, the phase detector gain factor can be determined efficiently.

In a seventh implementation form of the apparatus according to the fifth implementation form or the sixth implementation form of the first aspect, the apparatus further comprises a loop filter being configured to filter the first phase detection signal or the second phase detection signal using a loop filtering transfer function, and a further determiner being configured to determine the loop filtering transfer function of the loop filter upon the basis of the phase detector gain factor. Thus, the filtering transfer function of the loop filter can be adapted.

The loop filter can be an analog filter or a digital filter. The loop filter can be a proportional-integral (PI) filter. The loop filtering transfer function can determine a loop bandwidth of a phase-locked-loop (PLL). The further determiner can further determine the loop filtering transfer function of the loop filter upon the basis of a loop bandwidth, a dampingfactor, and/or a gain factor of the sampler.

In an eighth implementation form of the apparatus according to the first aspect as such or any preceding implementation form of the first aspect, the phase detector is configured to determine the first phase detection signal or the second phase detection signal according to the following equation:

$$y(n) = abs\left(x(n)\right)^{k} sign(x(n))sign(x(n+2)) - abs\left(x(n+2)\right)^{k} sign(x(n+2))sign(x(n))$$

wherein y denotes the first phase detection signal with x denoting the first filtered sampled communication signal, or wherein y denotes the second phase detection signal with x denoting the second filtered sampled communication signal, wherein n denotes a sampling time instant index, and k denotes a predetermined exponent parameter. Thus, the first phase detection signal or the second phase detection signal can be determined efficiently.

The predetermined exponent parameter can be a real number, e.g. 0.5 or 1.2. A timing error detector characteristic (TEDC) of the phase detector can consequently be adapted upon the basis of the predetermined exponent parameter.

In a ninth implementation form of the apparatus according to the first aspect as such or any preceding implementation form of the first aspect, the apparatus further comprises an equalizer being configured to equalize the sampled communication signal in time domain to obtain an equalized sampled communication signal. Thus, the sampled communication signal can be equalized.

The equalizer can be a feed-forward equalizer (FFE), a decision feed-back equalizer (DFE), a maximum likelihood sequence estimator (MLSE), or a combination thereof. The equalizer can reduce an inter-symbol-interference (ISI) effect of communication symbols within the sampled communication signal.

According to a second aspect, the invention relates to a method for synchronizing a sampling signal on a communication signal, the communication signal comprising communication symbols, the sampling signal indicating sampling time instants of the communication signal, the method comprising sampling the communication signal at the sampling time instants indicated by the sampling signal to obtain a sampled communication signal, filtering the sampled communication signal using a first filtering transfer function to obtain a first filtered sampled communication signal, determining a first phase detection signal upon the basis of the first filtered sampled communication signal, the first phase detection signal indicating a position of a sampling time instant within a communication symbol of the first filtered sampled communication signal, determining a first synchronicity measure upon the basis of the first phase detection signal, the first synchronicity measure indicating a synchronicity between the sampling signal and the communication signal, filtering the sampled communication signal using a second filtering transfer function to obtain a second filtered sampled communication signal, determining a second phase detection signal upon the basis of the second filtered sampled communication signal, the second phase detection signal indicating a position of a sampling time instant within a communication symbol of the second filtered sampled communication signal, determining a second synchronicity measure upon the basis of the second phase detection signal, the second synchronicity measure indicating a synchronicity between the sampling signal and the communication signal, and selecting the first filtering transfer function or the second filtering transfer function for filtering the sampled communication signal upon the basis of the first synchronicity measure and the second synchronicity measure for synchronizing the sampling signal on the communication signal, wherein the sampling signal is generated upon the basis of the first phase detection signal or the second phase detection signal. Thus, an efficient synchronization between the sampling signal and the communication signal can be realized.

The method can be performed by the apparatus. Further features of the method can directly result from the functionality of the apparatus.

In a first implementation form of the method according to the second aspect as such, the method further comprises delaying the sampled communication signal in time domain by a predetermined time delay to obtain a delayed sampled communication signal, filtering the delayed sampled communication signal using the first filtering transfer function to obtain a third filtered sampled communication signal, determining a third phase detection signal upon the basis of the third filtered sampled communication signal, the third phase detection signal indicating a position of a sampling time instant within a communication symbol of the third filtered sampled communication signal, filtering the delayed sampled communication signal using the second filtering transfer function to obtain a fourth filtered sampled communication signal, and determining a fourth phase detection signal upon the basis of the fourth filtered sampled communication signal, the fourth phase detection signal indicating a position of a sampling time instant within a communication symbol of the fourth filtered sampled communication signal, wherein determining the first synchronicity measure is further performed upon the basis of the third phase detection signal, and wherein determining the second synchronicity measure is further performed upon the basis of the fourth phase detection signal. Thus, the first synchronicity measure and the second synchronicity measure can be determined efficiently.

In a second implementation form of the method according to the first implementation form of the second aspect, the method further comprises weighting the third phase detection signal or the fourth phase detection signal by a predetermined weighting factor. Thus, an influence of the further filter and/or the further phase detector on the first synchronicity measure and the second synchronicity measure can be adapted.

According to a third aspect, the invention relates to a computer program comprising a program code for performing the method when executed on a computer. Thus, the method can be performed in an automatic and repeatable manner.

The computer program can be performed by the apparatus for performing the method. The apparatus can be programmably-arranged for performing the computer program.

The invention can be implemented in hardware and/or software.

Further implementation forms of the invention will be described with respect to the following figures, in which:

Fig. 1 shows a diagram of an apparatus for synchronizing a sampling signal on a communication signal according to an implementation form;

Fig. 2 shows a diagram of a method for synchronizing a sampling signal on a communication signal according to an implementation form;

Fig. 3 shows a diagram of an apparatus for synchronizing a sampling signal on a communication signal according to an implementation form;

Fig. 4 shows a diagram of an apparatus for synchronizing a sampling signal on a communication signal according to an implementation form;

Fig. 5 shows a diagram of a communication system for transmitting a communication signal from a communication transmitter over a communication channel to a communication receiver according to an implementation form;

Fig. 6 shows a diagram of a communication receiver for receiving a communication signal according to an implementation form;

Fig. 7 shows a diagram of a communication receiver for receiving a communication signal according to an implementation form;

Fig. 8 shows a diagram of a loop filter according to an implementation form;

Fig. 9 shows a diagram of a maximum timing error detector characteristic versus a chromatic dispersion value for different phase detectors according to an implementation form;

Fig. 10 shows a diagram of a synchronization accuracy of an apparatus for synchronizing a sampling signal on a communication signal according to an implementation form; and

Fig. 11 shows a diagram of a phase detector gain factor determination accuracy of an apparatus for synchronizing a sampling signal on a communication signal according to an implementation form.

## DETAILED DESCRIPTION OF IMPLEMENTATION FORMS OF THE INVENTION

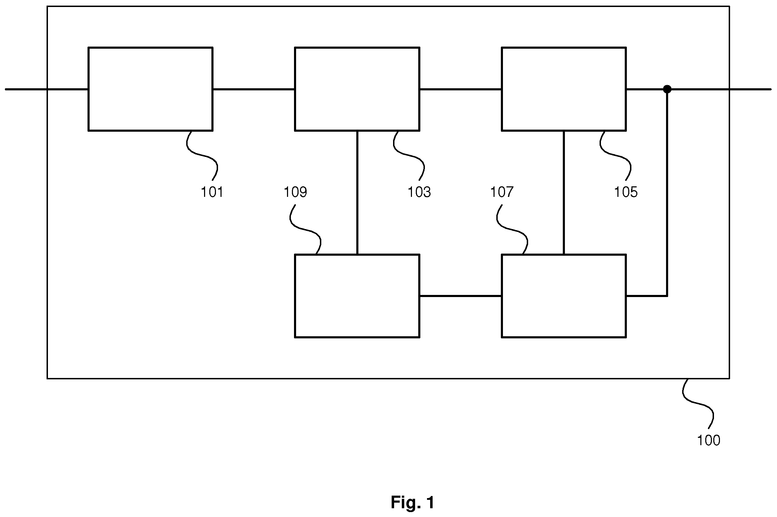

Fig. 1 shows a diagram of an apparatus 100 for synchronizing a sampling signal on a communication signal according to an implementation form. The communication signal comprises communication symbols. The sampling signal indicates sampling time instants of the communication signal.

The apparatus 100 comprises a sampler 101 being configured to sample the communication signal at the sampling time instants indicated by the sampling signal to obtain a sampled communication signal, a filter 103 being configured to filter the sampled communication signal using a first filtering transfer function to obtain a first filtered sampled communication signal, and to filter the sampled communication signal using a second filtering transfer function to obtain a second filtered sampled communication signal, a phase detector 105 being configured to determine a first phase detection signal upon the basis of the first filtered sampled communication signal, and to determine a second phase detection signal upon the basis of the second filtered sampled communication signal, the first phase detection signal indicating a position of a sampling time instant within a communication symbol of the first filtered sampled communication signal, the second phase detection signal indicating a position of a sampling time instant within a communication symbol of the second filtered sampled communication signal, a determiner 107 being configured to determine a first synchronicity measure upon the basis of the first phase detection signal, and to determine a second synchronicity measure upon the basis of the second phase detection signal, the first synchronicity measure and the second synchronicity measure indicating a synchronicity between the sampling signal and the communication signal, and a selector 109 being configured to select the first filtering transfer function or the second filtering transfer function of the filter for filtering the sampled communication signal upon the basis of the first synchronicity measure and the second synchronicity measure for synchronizing the sampling signal on the communication signal.

The apparatus 100 can be part of a communication receiver or can form a communication receiver. The communication receiver can be an optical communication receiver.

The sampler 101 can be an ADC. The filter 103 can be a digital filter, e.g. a digital FIR filter. The first filtering transfer function and the second filtering transfer function of the filter 103 can be determined by filter coefficients. The phase detector 105 can be an analog or a digital phase detector.

The determiner 107 can determine the first synchronicity measure and the second synchronicity measure upon the basis of a standard deviation and/or a mean deviation of sampling time instants within communication symbols. The selector 109 can select the first filtering transfer function or the second filtering transfer function being associated to an optimum, e.g. minimum, synchronicity measure.

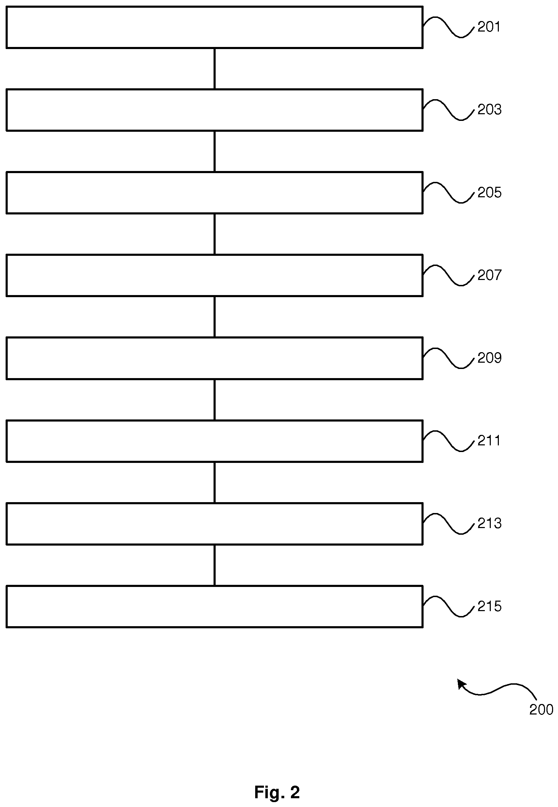

Fig. 2 shows a diagram of a method 200 for synchronizing a sampling signal on a communication signal according to an implementation form. The communication signal comprises communication symbols. The sampling signal indicates sampling time instants of the communication signal.

The method 200 comprises sampling 201 the communication signal at the sampling time instants indicated by the sampling signal to obtain a sampled communication signal, filtering 203 the sampled communication signal using a first filtering transfer function to obtain a first filtered sampled communication signal, determining 205 a first phase detection signal upon the basis of the first filtered sampled communication signal, the first phase detection signal indicating a position of a sampling time instant within a communication symbol of the first filtered sampled communication signal, determining 207 a first synchronicity measure upon the basis of the first phase detection signal, the first synchronicity measure indicating a synchronicity between the sampling signal and the communication signal, filtering 209 the sampled communication signal using a second filtering transfer function to obtain a second filtered sampled communication signal, determining 211 a second phase detection signal upon the basis of the second filtered sampled communication signal, the second phase detection signal indicating a position of a sampling time instant within a communication symbol of the second filtered sampled communication signal, determining 213 a second synchronicity measure upon the basis of the second phase detection signal, the second synchronicity measure indicating a synchronicity between the sampling signal and the communication signal, and selecting 215 the first filtering transfer function or the second filtering transfer function for filtering the sampled communication signal upon the basis of the first synchronicity measure and the second synchronicity measure for synchronizing the sampling signal on the communication signal.

The method 200 can be performed by the apparatus 100. Further features of the method 200 can directly result from the functionality of the apparatus 100.

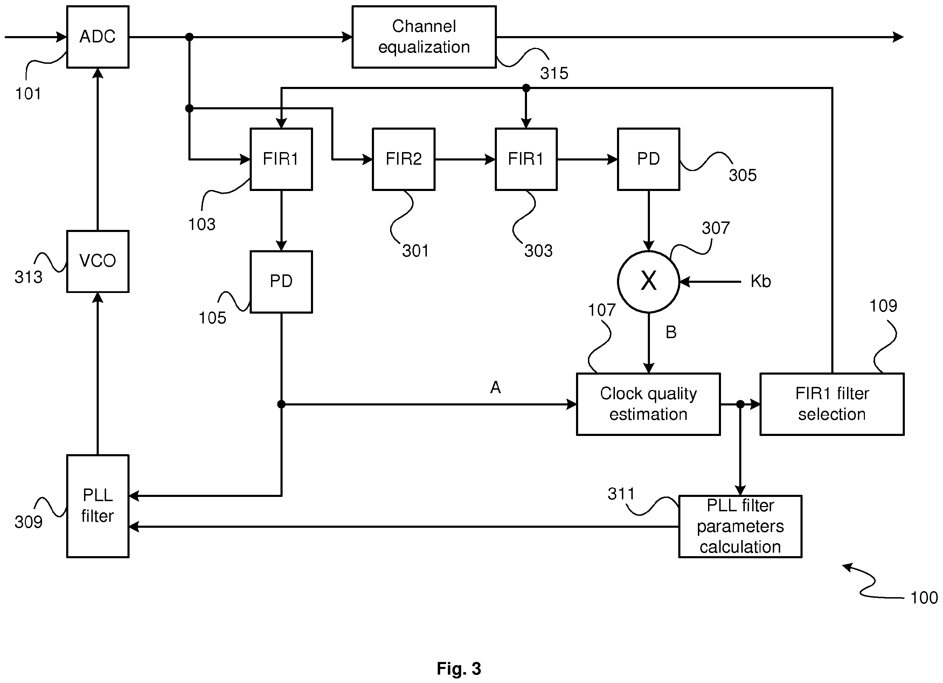

Fig. 3 shows a diagram of an apparatus 100 for synchronizing a sampling signal on a communication signal according to an implementation form. The diagram relates to symbol timing recovery.

The apparatus 100 comprises an ADC as sampler 101, an FIR1 filter as filter 103, a phase detector 105, a determiner 107 for clock quality estimation, and a selector 109 for FIR1 filter selection. The apparatus 100 further comprises an FIR2 filter as delayer 301, an FIR1 filter as further filter 303, a further phase detector 305, a multiplicator as weighter 307, a PLL filter as loop filter 309, a further determiner 311 for PLL filter parameter calculation, a VCO as sampling signal generator 313, and an equalizer 315 for communication channel equalization.

The apparatus 100 can be applied for an optimum timing recovery architecture selection in communication systems, e.g. optical communication systems, suffering from inter-symbol-interference (ISI), noise, and/or polarization mode dispersion (PMD). The apparatus 100 can provide a plurality of benefits. Firstly, the apparatus 100 can check a set of phase detector pre-filters using an algorithm which can estimate the clock tone quality. Secondly, after the best filter selection, the apparatus 100 can estimate a phase detector gain factor which can be used for setting timing recovery (TR) loop filter parameters. Thirdly, the apparatus 100 can be realized in a microcontroller which can decrease the realization complexity. Fourthly, the apparatus 100 can be applied in a number of communication systems, and may not be focused on optical communication systems.

The functionalities of the ADC as sampler 101, of the VCO as sampling signal generator 313, and of the PLL filter as loop filter 309 are explained in the following. They can be included in the apparatus 100 for timing recovery.

Two samples per communication symbol can be available after the sampler 101. Depending on the communication channel characteristics, filter coefficients of the filter 103 and/or the further filter 303, i.e. the FIR1 filters, can be optimized to achieve an excellent clock tone performance. The delayer 301, i.e. the FIR2 filter, can be used for communication signal interpolation. It can e.g. enable an estimation of a timing error detector characteristic (TEDC) at a sampling phase of T/8 from an equilibrium sampling phase, wherein T can denote the communication symbol time.

The signals A and B provided to the determiner 107 can be used in the clock quality estimation to estimate the influence of the filter 103 and/or the further filter 303, i.e. the FIR1 filters, on the clock recovery performance. After the final selection of the filtering transfer function of the filter 103 and/or the further filter 303, i.e. the FIR1 filters, the determiner 107 can provide data to the further determiner 311 which can configure the loop filter 309 of the PLL. The predetermined weighting factor Kb can depend on the communication channel distortion and can be set e.g. to 0.92 having a negligible influence to the final results.

The phase detector 105 and/or the further phase detector 305 can use one sample per communication symbol and its output y can be described by:

$$y(n) = abs\left(x(n)\right)^k sign(x(n))sign(x(n+2)) - abs\left(x(n+2)\right)^k sign(x(n+2))sign(x(n)) \quad (1)$$

wherein x(n) can denote input samples at a time distance of T/2. The exponent parameter k can be selected to minimize jitter, and the selection can depend on channel characteristics like optical fiber parameters, a communication link length, and/or an output signal-to-noise-ratio (OSNR). An optimum value of k can be in the range between 0.5 and 2.

The coefficients of the filter 103 and/or the further filter 303, i.e. of the FIR1 filters, can be described by a polynomial:

$$a(0) + a(1)Z^{-1} + ... + a(n-1)Z^{-(n-1)} \quad (2)$$

wherein $Z^{-1}$ can denote a time delay of T/2. For example, the coefficients of the filter 103 and/or the further filter 303, i.e. of the FIR1 filters, can be set to (1,3,4,3,1). The set of the filtering transfer functions can be checked. Then, an optimum filtering transfer function can be selected. In this case, the parameters of the PLL can be set to nominal values. After clock recovery, the filter quality of the filter 103 and/or the further filter 303, i.e. the FIR1 filters, can be estimated. It may happen that the VCO as sampling signal generator 313 is not locked to the input communication signal. In this case, the selected filtering transfer function can be discarded.

The FIR2 filter as delayer 301 can be defined by:

$$b(0) + b(1)Z^{-1} + b(2)Z^{-2} + b(3)Z^{-3} \quad (3)$$

wherein the coefficients b can e.g. be (-0.0938, 0.3438, 0.8438, -0.0938).

After locking of the VCO as sampling signal generator 313, the mean value of signal A can be equal or close to 0. The mean value of signal B can be greater than 0. The mean values of signals A and B can be measured in one block of data of a length of N symbols. M blocks of N symbols can provide M estimations. A synchronicity measure, also denoted as clock tone quality parameter (CTQP), can be determined as:

$$CTQP = \sqrt{\overline{(A - \overline{A})^2}} / \overline{B} \qquad (4)$$

The filtering transfer function of the filter 103 and/or further filter 303, i.e. of the FIR1 filters, having the lowest CTQP value can be selected. If the mean value of signal B is negative, the estimated filtering transfer function can be discarded. The CTQP can represent a ratio between a standard deviation of signal A and a mean value of signal B. Each estimation can be performed over N symbols.

Another parameter for loop dimensioning can be the phase detector gain factor $K_{pd}$ which can be equal to the mean value of signal B. In a second order loop, for the calculation of the loop parameters $K_i$ and $K_p$, the loop bandwidth, the damping factor, the gain of the VCO as sampling signal generator 313, and the gain of the phase detector 105 can be determined. The first three parameters can be known in advance. The fourth parameter, $K_{pd}$, can be determined. Circuits and algorithms for deriving this parameter can be provided.

The procedure can be summarized as follows. Firstly, select candidates of filtering transfer functions for the filter 103 and/or the further filter 303, i.e. the FIR1 filters. Secondly, set PLL parameters to nominal values, e.g. assume a phase detector gain factor $K_{pd} = 0.5$, a loop bandwidth of $10^{-4}/T$, and a damping factor of 1. Thirdly, use the filtering transfer functions and determine corresponding synchronicity measures, e.g. CTQPs. Fourthly, select an optimum filtering transfer function. Fifthly, determine the phase detector gain factor $K_{pd}$ using the optimum filtering transfer function. Sixthly, use the determined phase detector gain factor $K_{pd}$ to set the parameters of the loop filter 309 or PLL.

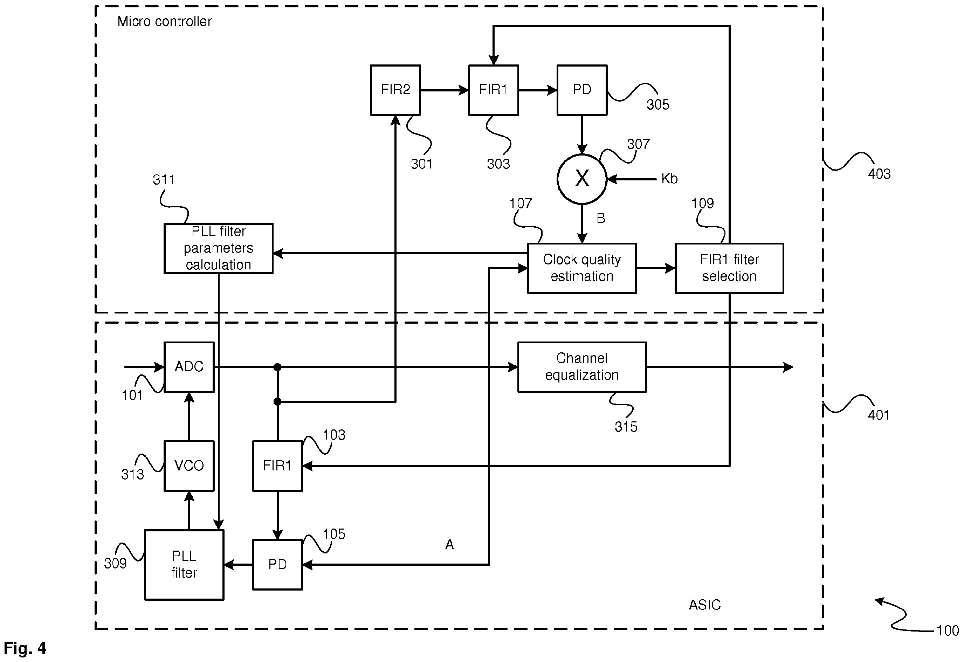

Fig. 4 shows a diagram of an apparatus 100 for synchronizing a sampling signal on a communication signal according to an implementation form. The diagram relates to symbol timing recovery.

The sampler 101, the filter 103, the phase detector 105, the loop filter 309, the sampling signal generator 313, and the equalizer 315 can be realized in an application-specific integrated-circuit 401. The determiner 107, the selector 109, the delayer 301, the further filter 303, the further phase detector 305, the weighter 307, and the further determiner 311 can be realized in a micro-controller 403.

The diagram relates to symbol timing recovery combining capabilities of the application-specific integrated-circuit 401 and the micro-controller 403. Therefore, a complexity saving can be achieved. The operations for timing recovery optimization can be performed at the beginning and periodically according to the speed of changes of the communication channel. Many operations can be realized in the micro-controller 403. The operations that can e.g. be performed by software are depicted. Therefore, the complexity can be reduced, the power consumption can be optimized, and the size can be decreased.

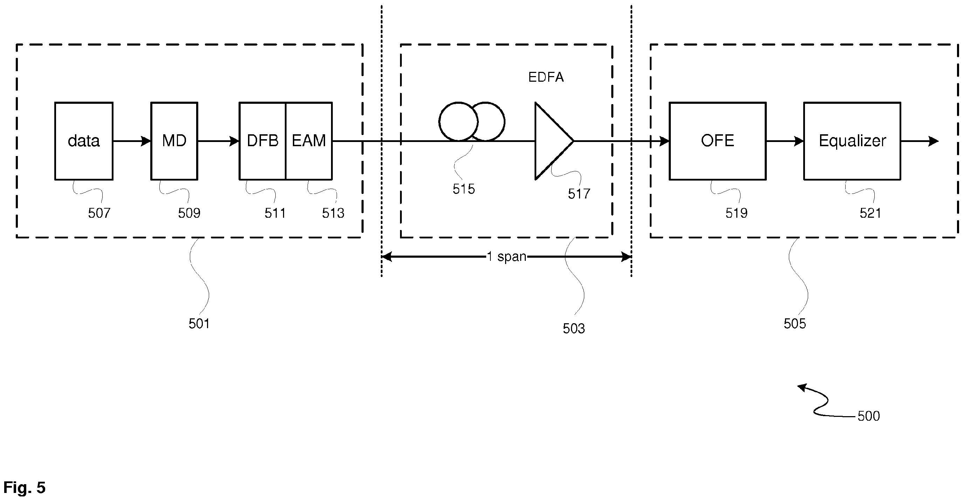

Fig. 5 shows a diagram of a communication system 500 for transmitting a communication signal from a communication transmitter 501 over a communication channel 503 to a communication receiver 505 according to an implementation form.

The communication transmitter 501 comprises a data source 507, a modulator driver (MD) 509, a distributed feedback laser (DFB) 511, and an electro-absorption modulator (EAM) 513. The communication channel 503 comprises an optical fiber 515, and an erbium-doped fiber amplifier (EDFA) 517. The communication receiver 505 comprises an optical front end (OFE) 519, and an equalizer 521. The communication channel 503 can cover one optical span.

The communication system 500 can relate to an On-Off-Keying (OOK) direct detection (DD) communication system. Circuits for synchronization or timing recovery selection and/or optimization can be applied. DD optical receivers can use enhanced digital signal processing techniques for equalization of impairments of the communication channel 503. Furthermore, synchronization or timing recovery can be performed.

A number of 10 Gb/s optical communication systems using the third wavelength window for transmitting data are deployed in dispersion compensated communication links. Chromatic dispersion in the third wavelength window, i.e. at wavelengths around 1550 nm, can be compensated using e.g. dispersion compensating fibers (DCFs) having an opposite dispersion sign than the applied fibers. Standard optical fibers can have a dispersion coefficient close to 16 ps/(nm.km). DCFs can usually be shorter than one optical span, i.e. approximately 80 km, and can have a higher dispersion coefficient. Using DCFs can cause negative effects such as higher noise, non-linear effects, and/or increased power.

A number of 40 Gb/s and 100 Gb/s coherent communication systems are deployed without DCF fibers. Based on coherent detection techniques and the linear nature of chromatic dispersion (CD), the chromatic dispersion can be compensated using enhanced digital signal processing (DSP) techniques. In specific communication systems, no DCF may be used at all. It can be preferred in short communication links without DCFs to use specific techniques to transmit high baud rate data. The main challenge in such communication systems can be the CD.

In optical communication links without dispersion compensation fibers, the communication signal suffering from CD and/or PMD can be equalized at the communication receiver 505. Several techniques for transmitting e.g. 10 Gb/s data over CD uncompensated communication links can use at the communication transmitter side an OOK modulated communication signal, a duo-binary communication transmitter, and/or a chirped modulated laser. The last two techniques may be more expensive than OOK and may provide a better performance in long communication links, e.g. almost double of the transmission length.

The communication receiver 505 can use a feed-forward equalizer (FFE), a decision feed-back equalizer (DFE), a maximum likelihood sequence estimator (MLSE), or a combination of them. FFE can suffer from noise enhancement, DFE can suffer from error multiplication, and MLSE can represent an optimized solution.

Optical communication transmitters can use a DFB laser 511 together with an EAM 513 integrated in transmit optical subassemblies (TOSA). The power of the optical communication signal can be proportional to the electrical communication signal modulating the laser.

At the optical communication receiver side, a photo diode, e.g. a positive intrinsic negative (PIN) diode or an avalanche photodiode (APD), can detect the optical communication signal. The output of the photo diode can be proportional to the optical communication signal power. The photo diode output can be amplified using a trans-impedance amplifier (TIA). The photo diode and the TIA can be integrated in receive optical subassemblies (ROSA) which may comprise an automatic gain control (AGC) block to adjust the electrical communication signal to an ADC input when electronic equalization is used.

A typical 10 Gb/s communication system 500 is depicted. The data of the data source 507 is amplified using a MD 509. The DFB laser 511 and the EAM 513 are responsible for modulation. The optical communication signal can be transmitted over several optical spans comprising an optical fiber 515 and an EDFA 517. The OFE 519 comprises a photo detector and an amplifier, which can usually be integrated in ROSA. The communication signal suffering from CD, PMD, and/or electrical bandwidth limitation can be equalized using an equalizer 521 formed by a FIR filter, a DFE, a MLSE, or a combination thereof.

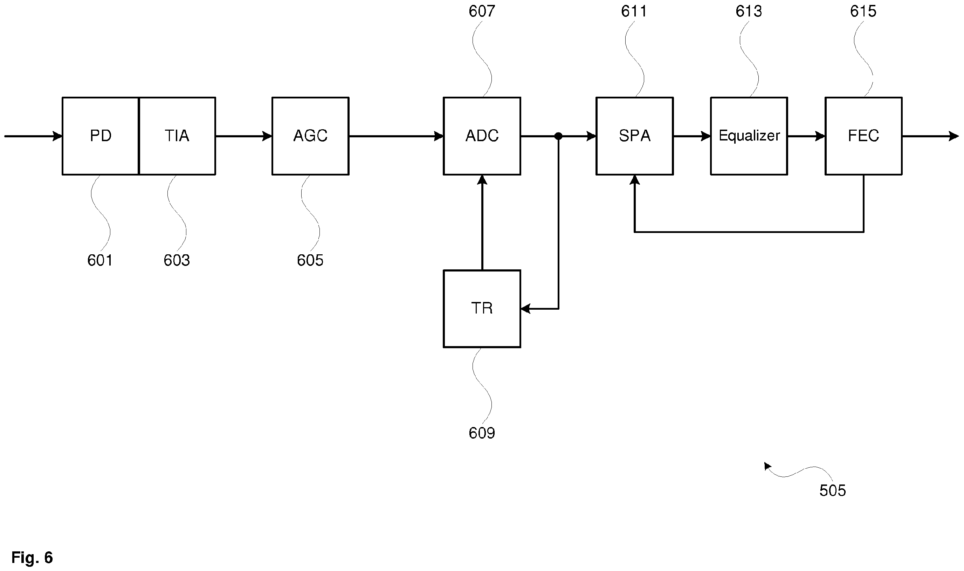

Fig. 6 shows a diagram of a communication receiver 505 for receiving a communication signal according to an implementation form.

The communication receiver 505 comprises a photo diode 601, a TIA 603, an AGC 605, an ADC 607, a timing recovery (TR) block 609, a sampling phase adjustment (SPA) block 611, an equalizer 613, and a forward error correction (FEC) block 615. The diagram depicts major functional blocks of the communication receiver 505.

The AGC 605 can monitor communication signal power variations and can realize an almost constant communication signal swing that can fit to the input range of the ADC 607. This way, the ADC 607 can be used effectively. With communication signals suffering from CD, it can be important that the communication signal is not clipped. Also, the communication signal magnitude may not be too small so that only a few levels of the ADC 607 are active. The equalizer 613 can recover communication signals suffering from noise and/or inter-symbol interference (ISI). However, before the equalizer 613 is activated, the local oscillator shall be locked to the input communication signal, i.e. to the communication transmitter oscillator responsible for data clocking. Therefore, two oscillators shall be synchronized.

Small deviations can be allowed since it can be challenging to track the communication transmitter clock source. A clock extraction can be enabled by a PD which can output information whether the sampling clock timing instant is higher or lower than desired. Since this information can be noisy suffering from pattern-dependent noise, noise caused by amplifiers, and/or component imperfections, the timing information can be filtered before entering the communication receiver oscillator, often realized as a VCO.

The timing information can be derived from the output signal of the ADC 607. The TR block 609 can comprise a PD, a loop filter and a VCO. The clock phase of the VCO can be adjusted using the SPA block 611 or circuit. A sampling phase optimization can be supported by the FEC block 615 which may provide a number of FEC input errors. The optimum sampling phase can minimize this number.

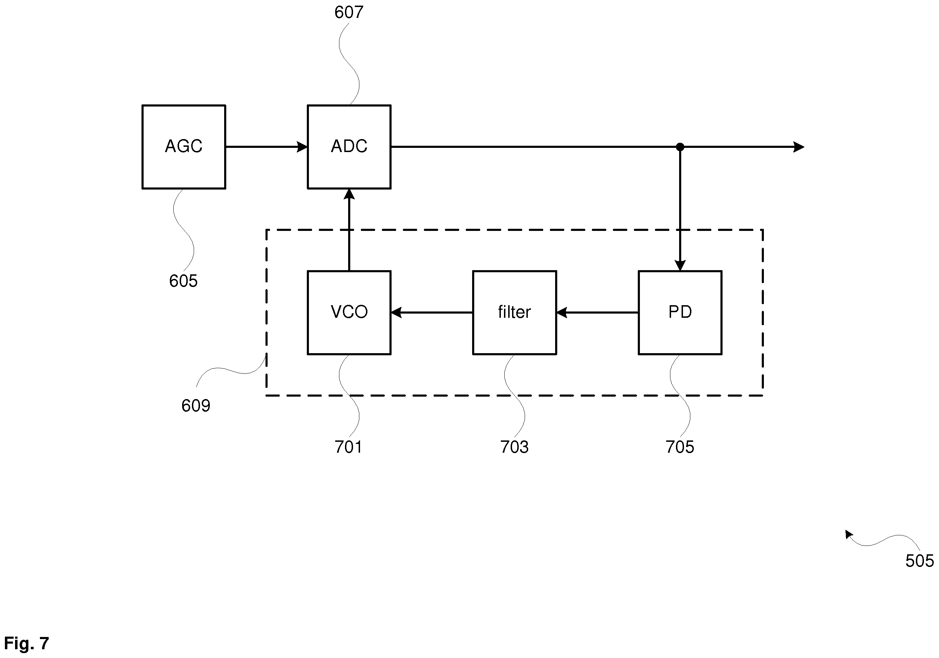

Fig. 7 shows a diagram of a communication receiver 505 for receiving a communication signal according to an implementation form.

The communication receiver 505 comprises an AGC 605, an ADC 607, and a TR block 609. The TR block 609 comprises a VCO 701, a loop filter 703, and a PD 705.

The communication receiver 505 can comprise an MLSE equalizer. Furthermore, a timing recovery can be realized. The output of the PD 705 is filtered by the loop filter 703 and is passed to the VCO 701. The closed loop can be denoted as PLL. The order of the loop can depend on the used loop filter 703. As loop filter 703, a proportional-integral (PI) filter can be used and can represent a second-order loop.

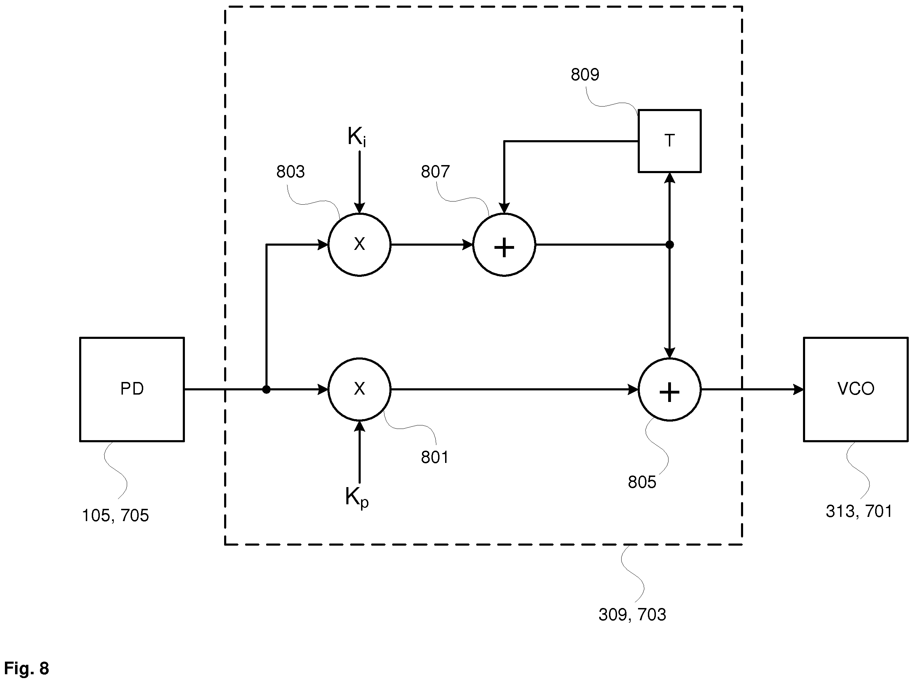

Fig. 8 shows a diagram of a loop filter 309, 703 according to an implementation form.

The loop filter 309, 703 comprises a first multiplier 801, a second multiplier 803, a first adder 805, a second adder 807, and a delayer 809. The first multiplier 801 comprises a multiplication factor $K_p$, and the second multiplier 803 comprises a multiplication factor $K_i$. The delayer 809 can realize a time delay of length $\tau$. The loop filter 309, 703 is connected to a phase detector 105, 705. The loop filter 309, 703 is further connected to a sampling signal generator 313 or voltage-controlled oscillator 701. The loop filter 309; 703 can be a PI filter.

The output of the phase detector 105, 705 can be fed into two branches, a proportional one and an integral one. The two signals can be multiplied by coefficients $K_p$ and $K_i$. The integral part can be delayed by one symbol time interval and summed up with the proportional part.

The loop can be characterized by a loop bandwidth and/or a damping factor. The selection of the loop parameters can depend on applications and standards. The PLL can be able to track the transmitter frequency and phase variations within the communication system specifications.

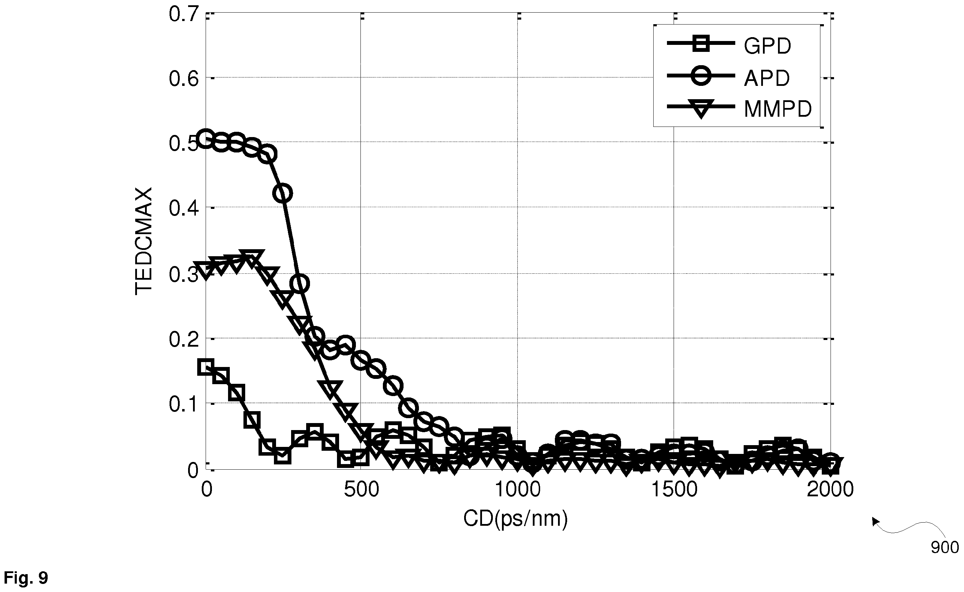

Fig. 9 shows a diagram 900 of a maximum timing error detector characteristic versus a chromatic dispersion value for different phase detectors according to an implementation form. The maximum timing error detector characteristic is abbreviated as TEDCMAX. The chromatic dispersion value is abbreviated as CD.

Different phase detectors, used in different communication systems, such as a Mueller and Muller phase detector (MMPD), an Alexander phase detector (APD), or a Gardner phase detector (GPD) can be applied.

The Mueller and Muller phase detector (MMPD) can work with one sample per communication symbol and can be described for real communication signals by

$$PD_{out}(k) = x(k+T)sign(x(k)) - x(k)sign(x(k+T))$$

wherein $T$ denotes the communication symbol time interval. The TEDC at a certain sampling phase can be an averaged value of the output of the PD at that sampling phase. It can be a periodic function with period T.

The APD can work on three real samples sampled at a time distance of T/2. The output of the PD can be equal to -1 if the sign of the third sample is different compared to the signs of the first two samples and can be equal to 1 if the sign of the first sample is different compared to the signs of the last two samples. The output can be 0 in all other cases.

The GPD can use three samples at a time distance of T/2. The rule of the PD for real communication signals can be defined by:

$$PD_{out}(k) = x(k+T/2)\big(x(k+T) - x(k)\big)$$

In CD uncompensated communication links using direct detection, the transmission distance can be limited by the capability of electronic dispersion compensation and the synchronization or timing recovery. A main challenge can be the ISI resulting from CD communication signal spreading.

The CD transfer function can be defined by

$$H(j\omega) = \exp\big(j\omega^2 K\big)$$

wherein the parameter K comprises a fiber CD parameter, a fiber length, the speed of light and a carrier frequency. Since the exponent comprises a squared frequency, the CD ISI effect can be four times worse in communication systems with twice higher frequency. For example, 10 Gb/s communication systems can be able to transmit over a distance of 80 km without communication receiver (Rx) equalization, whereas 20Gb/s communication systems may be feasible in communication links up to a distance of 20 km.

This can also be related to the bit error rate (BER) performance of the communication systems. At these limits, synchronization or timing recovery can generate jitter and can be prone to communication symbol slips.

A maximum of the timing error detector characteristic (TEDCMAX) can be estimated for different PDs over a CD value. The TEDCMAX can be an indicator of a synchronization or timing recovery failing area. Small TEDCMAX values can indicate challenging points. In this example, the OOK communication transmitter and DD communication receiver bandwidths can be approximately 10 GHz, the baud rate can be 28 GB/s, and the signal-to-noise ratio OSNR can be 22 dB. The results can indicate challenging PD points. A trend can be that the clock tone can get weaker at higher CD values. Additionally, the PDs can be sensitive to some specific CD values, e.g. 1050 ps/nm.

The main challenge can be to find a synchronization or timing recovery scheme and to calculate the parameters of the synchronization or timing recovery circuits.

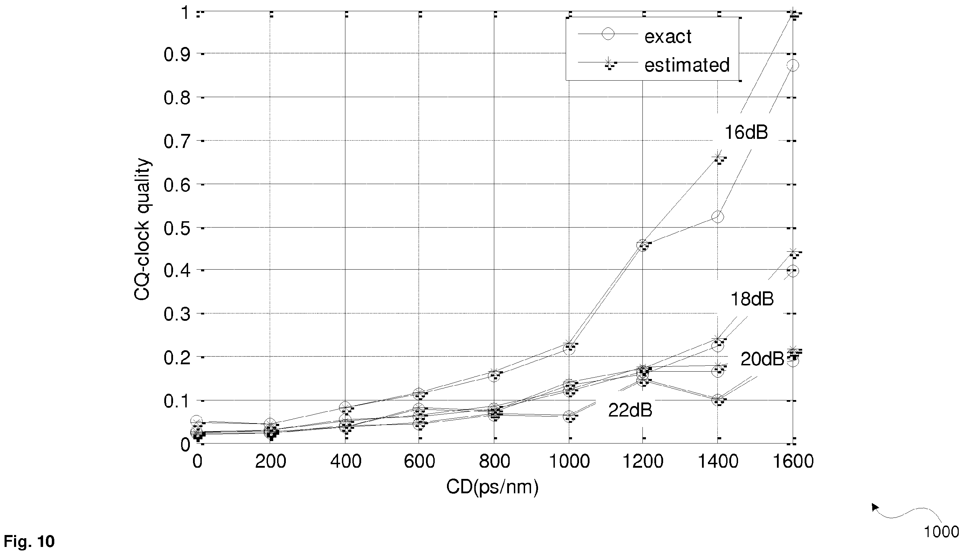

Fig. 10 shows a diagram 1000 of a synchronization accuracy of an apparatus for synchronizing a sampling signal on a communication signal according to an implementation form. The diagram 1000 relates to a synchronization measure estimation accuracy or a clock tone quality (CQ) estimation accuracy.

An exemplary 28 Gb/s OOK IM/DD communication system is investigated over a CD range from 0 to 1600 ps/nm in steps of 200 ps/nm. The output signal-to-noise-ratio (OSNR) is varied from 16 to 22 dB in steps of 2 dB. Different candidates of filters, e.g. FIR1 filters, can be employed. The filters, e.g. the FIR1 filters, selected by measuring jitter and the filters selected by the apparatus and/or method may be identical. The exact and estimated synchronization measures or CQ values can be close to each other.

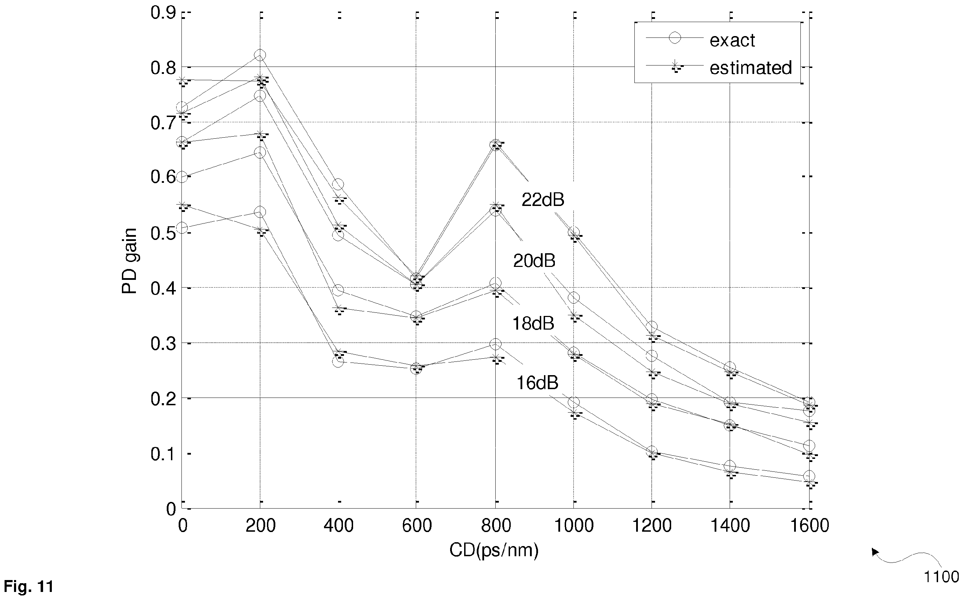

Fig. 11 shows a diagram 1100 of a phase detector gain factor determination accuracy of an apparatus for synchronizing a sampling signal on a communication signal according to an implementation form. The diagram relates to a phase detector gain factor estimation accuracy.

Regarding the same setup, the phase detector gain factor with the selected filters, e.g. FIR1 filters, can be estimated. The estimation accuracy is investigated. Estimation errors of up to 10% may not influence the loop bandwidth. Such variations can be encountered due to communication channel condition variations, and/or component aging. The estimation accuracy can be high.

The invention can relate to an apparatus and/or method for clock extraction and optimization in communication systems with direct detection suffering from ISI and/or noise. The invention can further relate to an apparatus and/or method for monitoring a sampling jitter via a synchronization measure, e.g. a clock tone quality parameter, that can indicate better and/or optimum circuit configurations if existing.

### Claims

1. An apparatus (100) for synchronizing a sampling signal on a communication signal, the communication signal comprising communication symbols, the sampling signal indicating sampling time instants of the communication signal, the apparatus (100) comprising:

   a sampler (101) being configured to sample the communication signal at the sampling time instants indicated by the sampling signal to obtain a sampled communication signal;
   a filter (103) being configured to filter the sampled communication signal using a first filtering transfer function to obtain a first filtered sampled communication signal, and to filter the sampled communication signal using a second filtering transfer function to obtain a second filtered sampled communication signal;
   a phase detector (105) being configured to determine a first phase detection signal upon the basis of the first filtered sampled communication signal, and to determine a second phase detection signal upon the basis of the second filtered sampled communication signal, the first phase detection signal indicating a position of a sampling time instant within a communication symbol of the first filtered sampled communication signal, the second phase detection signal indicating a position of a sampling time instant within a communication symbol of the second filtered sampled communication signal;
   **characterized by** the apparatus further comprising:

   a determiner (107) being configured to determine a first synchronicity measure upon the basis of the first phase detection signal, and to determine a second synchronicity measure upon the basis of the second phase detection signal, the first synchronicity measure and the second synchronicity measure indicating a synchronicity between the sampling signal and the communication signal;
   a selector (109) being configured to select the first filtering transfer function or the second filtering transfer function of the filter (103) for filtering the sampled communication signal upon the basis of the first synchronicity measure and the second synchronicity measure for synchronizing the sampling signal on the communication signal; and
   a sampling signal generator (313) being configured to generate the sampling signal upon the basis of the first phase detection signal, or to generate the sampling signal upon the basis of the second phase detection signal.

2. The apparatus (100) of claim 1, further comprising:

   a delayer (301) being configured to delay the sampled communication signal in time domain by a predetermined time delay to obtain a delayed sampled communication signal;
   a further filter (303) being configured to filter the delayed sampled communication signal using the first filtering transfer function to obtain a third filtered sampled communication signal, and to filter the delayed sampled communication signal using the second filtering transfer function to obtain a fourth filtered sampled communication signal; and
   a further phase detector (305) being configured to determine a third phase detection signal upon the basis of the third filtered sampled communication signal, and to determine a fourth phase detection signal upon the basis of the fourth filtered sampled communication signal, the third phase detection signal indicating a position of a sampling time instant within a communication symbol of the third filtered sampled communication signal, the fourth phase detection signal indicating a position of a sampling time instant within a communication symbol of the fourth filtered sampled communication signal;

wherein the determiner (107) is further configured to determine the first synchronicity measure upon the basis of the third phase detection signal, and to determine the second synchronicity measure upon the basis of the fourth phase detection signal.

3. The apparatus (100) of claim 2, wherein the delayer (301) comprises an interpolation filter being configured to interpolate the sampled communication signal in time domain to obtain the delayed sampled communication signal.

4. The apparatus (100) of claims 2 or 3, further comprising:
a weighter (307) being configured to weight the third phase detection signal or the fourth phase detection signal by a predetermined weighting factor.

5. The apparatus (100) of claims 2 to 4, wherein the determiner (107) is configured to determine the first synchronicity measure or the second synchronicity measure according to the following equation:

$$CTQP = \sqrt{\overline{(A - \overline{A})^2}} / \overline{B}$$

wherein CTQP denotes the first synchronicity measure with A denoting the first phase detection signal, B denoting the third phase detection signal, $\overline{A}$ denoting a mean value of the first phase detection signal, and $\overline{B}$ denoting a mean value of the third phase detection signal, or wherein CTQP denotes the second synchronicity measure with A denoting the second phase detection signal, B denoting the fourth phase detection signal, $\overline{A}$ denoting a mean value of the second phase detection signal, and $\overline{B}$ denoting a mean value of the fourth phase detection signal.

6. The apparatus (100) of claims 2 to 5, wherein the determiner (107) is further configured to determine a phase detector gain factor upon the basis of the third phase detection signal or the fourth phase detection signal, the phase detector gain factor indicating a magnitude of the first phase detection signal or the second phase detection signal in dependence of a position of a sampling time instant within a communication symbol of the first filtered sampled communication signal or the second filtered sampled communication signal.

7. The apparatus (100) of claim 6, wherein the determiner (107) is configured to determine the phase detector gain factor upon the basis of the third phase detection signal or the fourth phase detection signal according to the following equation:

$$K_{pd} = \overline{B}$$

wherein $K_{pd}$ denotes the phase detector gain factor, and $\overline{B}$ denotes a mean value of the third phase detection signal or the fourth phase detection signal.

8. The apparatus (100) of claims 6 or 7, further comprising:

a loop filter (309) being configured to filter the first phase detection signal or the second phase detection signal using a loop filtering transfer function; and
a further determiner (311) being configured to determine the loop filtering transfer function of the loop filter (309) upon the basis of the phase detector gain factor.

9. The apparatus (100) of any of the preceding claims, wherein the phase detector (105) is configured to determine the first phase detection signal or the second phase detection signal according to the following equation:

$$y(n) = abs\left(x(n)\right)^k sign(x(n))sign(x(n+2)) - abs\left(x(n+2)\right)^k sign(x(n+2))sign(x(n))$$

wherein y denotes the first phase detection signal with x denoting the first filtered sampled communication signal, or wherein y denotes the second phase detection signal with x denoting the second filtered sampled communication signal, wherein n denotes a sampling time instant index, and k denotes a predetermined exponent parameter.

**10.** The apparatus (100) of any of the preceding claims, further comprising:
an equalizer (315) being configured to equalize the sampled communication signal in time domain to obtain an equalized sampled communication signal.

**11.** A method (200) for synchronizing a sampling signal on a communication signal, the communication signal comprising communication symbols, the sampling signal indicating sampling time instants of the communication signal, the method (200) comprising:

Sampling (201) the communication signal at the sampling time instants indicated by the sampling signal to obtain a sampled communication signal;
Filtering (203) the sampled communication signal using a first filtering transfer function to obtain a first filtered sampled communication signal; and
Determining (205) a first phase detection signal upon the basis of the first filtered sampled communication signal, the first phase detection signal indicating a position of a sampling time instant within a communication symbol of the first filtered sampled communication signal;
**characterized by** the method further comprising:

Determining (207) a first synchronicity measure upon the basis of the first phase detection signal, the first synchronicity measure indicating a synchronicity between the sampling signal and the communication signal;
Filtering (209) the sampled communication signal using a second filtering transfer function to obtain a second filtered sampled communication signal;
Determining (211) a second phase detection signal upon the basis of the second filtered sampled communication signal, the second phase detection signal indicating a position of a sampling time instant within a communication symbol of the second filtered sampled communication signal;
Determining (213) a second synchronicity measure upon the basis of the second phase detection signal, the second synchronicity measure indicating a synchronicity between the sampling signal and the communication signal; and
Selecting (215) the first filtering transfer function or the second filtering transfer function for filtering the sampled communication signal upon the basis of the first synchronicity measure and the second synchronicity measure for synchronizing the sampling signal on the communication signal;

wherein the sampling signal is generated upon the basis of the first phase detection signal or the second phase detection signal.

**12.** The method (200) of claim 11, further comprising:

Delaying the sampled communication signal in time domain by a predetermined time delay to obtain a delayed sampled communication signal;
Filtering the delayed sampled communication signal using the first filtering transfer function to obtain a third filtered sampled communication signal;
Determining a third phase detection signal upon the basis of the third filtered sampled communication signal, the third phase detection signal indicating a position of a sampling time instant within a communication symbol of the third filtered sampled communication signal;
Filtering the delayed sampled communication signal using the second filtering transfer function to obtain a fourth filtered sampled communication signal; and
Determining a fourth phase detection signal upon the basis of the fourth filtered sampled communication signal, the fourth phase detection signal indicating a position of a sampling time instant within a communication symbol of the fourth filtered sampled communication signal;
wherein determining (207) the first synchronicity measure is further performed upon the basis of the third phase detection signal, and wherein determining (213) the second synchronicity measure is further performed upon the basis of the fourth phase detection signal.

**13.** The method (200) of claim 12, further comprising:
Weighting the third phase detection signal or the fourth phase detection signal by a predetermined weighting factor.

**14.** A computer program comprising a program code for performing the method (200) of any of the claims 11 to 13 when executed on a computer.

**Patentansprüche**

1.  Vorrichtung (100) zum Synchronisieren eines Abtastsignals an einem Kommunikationssignal, wobei das Kommunikationssignal Kommunikationssymbole umfasst und das Abtastsignal Abtastzeitpunkte des Kommunikationssignals angibt, wobei die Vorrichtung (100) Folgendes umfasst:

    einen Abtaster (101), der ausgelegt ist zum Abtasten des Kommunikationssignals zu den Abtastzeitpunkten, die durch das Abtastsignal angegeben werden, um ein abgetastetes Kommunikationssignal zu erhalten;
    ein Filter (103), das ausgelegt ist zum Filtern des abgetasteten Kommunikationssignals unter Verwendung einer ersten Filtertransferfunktion, um ein erstes gefiltertes abgetastetes Kommunikationssignal zu erhalten, und zum Filtern des abgetasteten Kommunikationssignals unter Verwendung einer zweiten Filtertransferfunktion, um ein zweites gefiltertes abgetastetes Kommunikationssignal zu erhalten;
    einen Phasendetektor (105), der ausgelegt ist zum Bestimmen eines ersten Phasendetektionssignals auf Basis des ersten gefilterten abgetasteten Kommunikationssignals und zum Bestimmen eines zweiten Phasendetektionssignals auf Basis des zweiten gefilterten abgetasteten Kommunikationssignals, wobei das erste Phasendetektionssignal eine Position eines Abtastzeitpunkts innerhalb eines Kommunikationssymbols des ersten gefilterten abgetasteten Kommunikationssignals angibt und das zweite Phasendetektionssignal eine Position eines Abtastzeitpunkts innerhalb eines Kommunikationssymbols des zweiten gefilterten abgetasteten Kommunikationssignals angibt;
    **dadurch gekennzeichnet, dass** die Vorrichtung ferner Folgendes umfasst:

    einen Bestimmer (107), der ausgelegt ist zum Bestimmen eines ersten Synchronizitätsmaßes auf Basis des ersten Phasendetektionssignals und zum Bestimmen eines zweiten Synchronizitätsmaßes auf Basis des zweiten Phasendetektionssignals, wobei das erste Synchronizitätsmaß und das zweite Synchronizitätsmaß eine Synchronizität zwischen dem Abtastsignal und dem Kommunikationssignal angeben;
    einen Selektor (109), der ausgelegt ist zum Auswählen der ersten Filtertransferfunktion oder der zweiten Filtertransferfunktion des Filters (103) zum Filtern des abgetasteten Kommunikationssignals auf Basis des ersten Synchronizitätsmaßes und des zweiten Synchronizitätsmaßes zum Synchronisieren des abgetasteten Signals am Kommunikationssignal; und
    einen Abtastsignalgenerator (313), der ausgelegt ist zum Erzeugen des Abtastsignals auf Basis des ersten Phasendetektionssignals oder zum Erzeugen des Abtastsignals auf Basis des zweiten Phasendetektionssignals.

2.  Vorrichtung (100) nach Anspruch 1, die ferner Folgendes umfasst:

    einen Verzögerer (301), der ausgelegt ist zum Verzögern des abgetasteten Kommunikationssignals im Zeitbereich um eine vorbestimmte Zeitverzögerung, um ein verzögertes abgetastetes Kommunikationssignal zu erhalten;
    ein weiteres Filter (303), das ausgelegt ist zum Filtern des verzögerten abgetasteten Kommunikationssignals unter Verwendung der ersten Filtertransferfunktion, um ein drittes gefiltertes abgetastetes Kommunikationssignal zu erhalten, und zum Filtern des verzögerten abgetasteten Kommunikationssignals unter Verwendung der zweiten Filtertransferfunktion, um ein viertes gefiltertes abgetastetes Kommunikationssignal zu erhalten; und
    einen weiteren Phasendetektor (305), der ausgelegt ist zum Bestimmen eines dritten Phasendetektionssignals auf Basis des dritten gefilterten abgetasteten Kommunikationssignals und zum Bestimmen eines vierten Phasendetektionssignals auf Basis des vierten gefilterten abgetasteten Kommunikationssignals, wobei das dritte Phasendetektionssignal eine Position eines Abtastzeitpunkts innerhalb eines Kommunikationssymbols des dritten gefilterten abgetasteten Kommunikationssignals angibt und das vierte Phasendetektionssignal eine Position eines Abtastzeitpunkts innerhalb eines Kommunikationssymbols des vierten gefilterten abgetasteten Kommunikationssignals angibt;
    wobei der Bestimmer (107) ferner ausgelegt ist zum Bestimmen des ersten Synchronizitätsmaßes auf Basis des dritten Phasendetektionssignals und zum Bestimmen des zweiten Synchronizitätsmaßes auf Basis des vierten Phasendetektionssignals.

3.  Vorrichtung (100) nach Anspruch 2, wobei der Verzögerer (301) ein Interpolationsfilter umfasst, das ausgelegt ist zum Interpolieren des abgetasteten Kommunikationssignals im Zeitbereich, um das verzögerte abgetastete Kommunikationssignal zu erhalten.

4.  Vorrichtung (100) nach den Ansprüchen 2 oder 3, die ferner Folgendes umfasst:

einen Gewichter (307), der ausgelegt ist zum Gewichten des dritten Phasendetektionssignals oder des vierten Phasendetektionssignals um einen vorbestimmten Gewichtungsfaktor.

5. Vorrichtung (100) nach den Ansprüchen 2 bis 4, wobei der Bestimmer (107) ausgelegt ist zum Bestimmen des ersten Synchronizitätsmaßes oder des zweiten Synchronizitätsmaßes gemäß der folgenden Gleichung:

$$CTQP = \sqrt{\overline{(A - \bar{A})^2}/\bar{B}}$$

wobei CTQP das erste Synchronizitätsmaß bezeichnet, worin A das erste Phasendetektionssignal, B das dritte Phasendetektionssignal bezeichnet, $\bar{A}$ einen Mittelwert des ersten Phasendetektionssignals bezeichnet und $\bar{B}$ einen Mittelwert des dritten Phasendetektionssignals bezeichnet, oder wobei CTQP das zweite Synchronizitätsmaß bezeichnet, worin A das zweite Phasendetektionssignal bezeichnet, B das vierte Phasendetektionssignal bezeichnet, $\bar{A}$ einen Mittelwert des zweiten Phasendetektionssignals bezeichnet und $\bar{B}$ einen Mittelwert des vierten Phasendetektionssignals bezeichnet.

6. Vorrichtung (100) nach den Ansprüchen 2 bis 5, wobei der Bestimmer (107) ferner ausgelegt ist zum Bestimmen eines Phasendetektorverstärkungsfaktors auf Basis des dritten Phasendetektionssignals oder des vierten Phasendetektionssignals, wobei der Phasendetektorverstärkungsfaktor eine Größe des ersten Phasendetektionssignals oder des zweiten Phasendetektionssignals in Abhängigkeit von einer Position eines Abtastzeitpunkts innerhalb eines Kommunikationssymbols des ersten gefilterten abgetasteten Kommunikationssignals oder des zweiten gefilterten abgetasteten Kommunikationssignals angibt.

7. Vorrichtung (100) nach Anspruch 6, wobei der Bestimmer (107) ausgelegt ist zum Bestimmen des Phasendetektorverstärkungsfaktors auf Basis des dritten Phasendetektionssignals oder des vierten Phasendetektionssignals gemäß der folgenden Gleichung:

$$\mathrm{K}_{\mathrm{pd}} = \bar{B}$$

wobei $K_{pd}$ den Phasendetektorverstärkungsfaktor bezeichnet und $\bar{B}$ einen Mittelwert des dritten Phasendetektionssignals oder des vierten Phasendetektionssignals bezeichnet.

8. Vorrichtung (100) nach den Ansprüchen 6 oder 7, die ferner Folgendes umfasst:

ein Schleifenfilter (309), das ausgelegt ist zum Filtern des ersten Phasendetektionssignals oder des zweiten Phasendetektionssignals unter Verwendung einer Schleifenfiltertransferfunktion; und
einen weiteren Bestimmer (311), der ausgelegt ist zum Bestimmen der Schleifenfiltertransferfunktion des Schleifenfilters (309) auf Basis des Phasendetektorverstärkungsfaktors.

9. Vorrichtung (100) nach einem der vorangegangenen Ansprüche, wobei der Phasendetektor (105) ausgelegt ist zum Bestimmen des ersten Phasendetektionssignals oder des zweiten Phasendetektionssignals gemäß der folgenden Gleichung:

$$y(n) = abs\big(x(n)\big)^{k} sign\big(x(n)\big) sign\big(x(n+2)\big) - abs\big(x(n+2)\big)^{k} sign\big(x(n+2)\big) sign\big(x(n)\big)$$

wobei y das erste Phasendetektionssignal bezeichnet, worin x das erste gefilterte abgetastete Kommunikationssignal bezeichnet, oder wobei y das zweite Phasendetektionssignal bezeichnet, worin x das zweite gefilterte abgetastete Kommunikationssignal bezeichnet, wobei n einen Abtastzeitpunktindex bezeichnet und k einen vorbestimmten Exponentenparameter bezeichnet.

10. Vorrichtung (100) nach einem der vorangegangenen Ansprüche, die ferner Folgendes umfasst:
einen Entzerrer (315), der ausgelegt ist zum Entzerren des abgetasteten Kommunikationssignals im Zeitbereich, um ein entzerrtes abgetastetes Kommunikationssignal zu erhalten.

**11.** Verfahren (200) zum Synchronisieren eines Abtastsignals an einem Kommunikationssignal, wobei das Kommunikationssignal Kommunikationssymbole umfasst und das Abtastsignal Abtastzeitpunkte des Kommunikationssignals angibt, wobei das Verfahren (200) Folgendes umfasst:

Abtasten (201) des Kommunikationssignals an den Abtastzeitpunkten, die durch das Abtastsignal angegeben werden, um ein abgetastetes Kommunikationssignal zu erhalten;

Filtern (203) des abgetasteten Kommunikationssignals unter Verwendung einer ersten Filtertransferfunktion, um ein erstes gefiltertes abgetastetes Kommunikationssignal zu erhalten; und

Bestimmen (205) eines ersten Phasendetektionssignals auf Basis des ersten gefilterten abgetasteten Kommunikationssignals, wobei das erste Phasendetektionssignal eine Position eines Abtastzeitpunkts innerhalb eines Kommunikationssymbols des ersten gefilterten abgetasteten Kommunikationssignals angibt;

**dadurch gekennzeichnet, dass** das Verfahren ferner Folgendes umfasst:

Bestimmen (207) eines ersten Synchronizitätsmaßes auf Basis des ersten Phasendetektionssignals, wobei das erste Synchronizitätsmaß eine Synchronizität zwischen dem Abtastsignal und dem Kommunikationssignal angibt;

Filtern (209) des abgetasteten Kommunikationssignals unter Verwendung einer zweiten Filtertransferfunktion, um ein zweites gefiltertes abgetastetes Kommunikationssignal zu erhalten;

Bestimmen (211) eines zweiten Phasendetektionssignals auf Basis des zweiten gefilterten abgetasteten Kommunikationssignals, wobei das zweite Phasendetektionssignal eine Position eines Abtastzeitpunkts innerhalb eines Kommunikationssymbols des zweiten gefilterten abgetasteten Kommunikationssignals angibt;

Bestimmen (213) eines zweiten Synchronizitätsmaßes auf Basis des zweiten Phasendetektionssignals, wobei das zweite Synchronizitätsmaß eine Synchronizität zwischen dem Abtastsignal und dem Kommunikationssignal angibt; und

Auswählen (215) der ersten Filtertransferfunktion oder der zweiten Filtertransferfunktion zum Filtern des abgetasteten Kommunikationssignals auf Basis des ersten Synchronizitätsmaßes und des zweiten Synchronizitätsmaßes zum Synchronisieren des Abtastsignals am Kommunikationssignal;

wobei das Abtastsignal auf Basis des ersten Phasendetektionssignals oder des zweiten Phasendetektionssignals erzeugt wird.

**12.** Verfahren (200) nach Anspruch 11, das ferner Folgendes umfasst:

Verzögern des abgetasteten Kommunikationssignals im Zeitbereich um eine vorbestimmte Zeitverzögerung, um ein verzögertes abgetastetes Kommunikationssignal zu erhalten;

Filtern des verzögerten abgetasteten Kommunikationssignals unter Verwendung der ersten Filtertransferfunktion, um ein drittes gefiltertes abgetastetes Kommunikationssignal zu erhalten;

Bestimmen eines dritten Phasendetektionssignals auf Basis des dritten gefilterten abgetasteten Kommunikationssignals, wobei das dritte Phasendetektionssignal eine Position eines Abtastzeitpunkts innerhalb eines Kommunikationssymbols des dritten gefilterten abgetasteten Kommunikationssignals angibt;

Filtern des verzögerten abgetasteten Kommunikationssignals unter Verwendung der zweiten Filtertransferfunktion, um ein viertes gefiltertes abgetastetes Kommunikationssignal zu erhalten; und

Bestimmen eines vierten Phasendetektionssignals auf Basis des vierten gefilterten abgetasteten Kommunikationssignals, wobei das vierte Phasendetektionssignal eine Position eines Abtastzeitpunkts innerhalb eines Kommunikationssymbols des vierten gefilterten abgetasteten Kommunikationssignals angibt;

wobei das Bestimmen (207) des ersten Synchronizitätsmaßes ferner auf Basis des dritten Phasendetektionssignals durchgeführt wird und wobei das Bestimmen (213) des zweiten Synchronizitätsmaßes ferner auf Basis des vierten Phasendetektionssignals durchgeführt wird.

**13.** Verfahren (200) nach Anspruch 12, das ferner Folgendes umfasst:
Gewichten des dritten Phasendetektionssignals oder des vierten Phasendetektionssignals um einen vorbestimmten Gewichtungsfaktor.

**14.** Computerprogramm, das einen Programmcode zum Durchführen des Verfahrens (200) nach einem der Ansprüche 11 bis 13, wenn er auf einem Computer ausgeführt wird, umfasst.

**Revendications**

1.  Appareil (100) pour synchroniser un signal d'échantillonnage sur un signal de communication, le signal de communication comprenant des symboles de communication, le signal d'échantillonnage indiquant des instants d'échantillonnage du signal de communication, l'appareil (100) comprenant :

    un échantillonneur (101) configuré pour échantillonner le signal de communication aux instants d'échantillonnage indiqués par le signal d'échantillonnage pour obtenir un signal de communication échantillonné ;
    un filtre (103) configuré pour filtrer le signal de communication échantillonné à l'aide d'une première fonction de transfert de filtrage pour obtenir un premier signal de communication échantillonné filtré, et filtrer le signal de communication échantillonné à l'aide d'une seconde fonction de transfert de filtrage pour obtenir un deuxième signal de communication échantillonné filtré ;
    un détecteur de phase (105) configuré pour déterminer un premier signal de détection de phase sur la base du premier signal de communication échantillonné filtré, et pour déterminer un deuxième signal de détection de phase sur la base du deuxième signal de communication échantillonné filtré, le premier signal de détection de phase indiquant une position d'un instant d'échantillonnage à l'intérieur d'un symbole de communication du premier signal de communication échantillonné filtré, le deuxième signal de détection de phase indiquant une position d'un instant d'échantillonnage à l'intérieur d'un symbole de communication du deuxième signal de communication échantillonné filtré ;
    l'appareil étant **caractérisé en ce qu'**il comprend en outre :

    un dispositif de détermination (107) configuré pour déterminer une première mesure de synchronicité sur la base du premier signal de détection de phase, et pour déterminer une seconde mesure de synchronicité sur la base du deuxième signal de détection de phase, la première mesure de synchronicité et la seconde mesure de synchronicité indiquant une synchronicité entre le signal d'échantillonnage et le signal de communication ;
    un sélecteur (109) configuré pour sélectionner la première fonction de transfert de filtrage ou la seconde fonction de transfert de filtrage du filtre (103) pour filtrer le signal de communication échantillonné sur la base de la première mesure de synchronicité et de la seconde mesure de synchronicité pour synchroniser le signal d'échantillonnage sur le signal de communication ; et
    un générateur de signal d'échantillonnage (313) configuré pour générer le signal d'échantillonnage sur la base du premier signal de détection de phase, ou pour générer le signal d'échantillonnage sur la base du deuxième signal de détection de phase.

2.  Appareil (100) selon la revendication 1, comprenant en outre :

    un dispositif de retardement (301) configuré pour retarder le signal de communication échantillonné dans le domaine temporel d'un retard temporel prédéterminé pour obtenir un signal de communication échantillonné retardé ;
    un filtre supplémentaire (303) configuré pour filtrer le signal de communication échantillonné retardé à l'aide de la première fonction de transfert de filtrage pour obtenir un troisième signal de communication échantillonné filtré, et pour filtrer le signal de communication échantillonné retardé à l'aide de la seconde fonction de transfert de filtrage pour obtenir un quatrième signal de communication échantillonné filtré ; et
    un détecteur supplémentaire de phase (305) configuré pour déterminer un troisième signal de détection de phase sur la base du troisième signal de communication échantillonné filtré, et pour déterminer un quatrième signal de détection de phase sur la base du quatrième signal de communication échantillonné filtré, le troisième signal de détection de phase indiquant une position d'un instant d'échantillonnage à l'intérieur d'un symbole de communication du troisième signal de communication échantillonné filtré, le quatrième signal de détection de phase indiquant une position d'un instant d'échantillonnage à l'intérieur d'un symbole de communication du quatrième signal de communication échantillonné filtré ;
    le dispositif de détermination (107) étant en outre configuré pour déterminer la première mesure de synchronicité sur la base du troisième signal de détection de phase, et pour déterminer la seconde mesure de synchronicité sur la base du quatrième signal de détection de phase.

3.  Appareil (100) selon la revendication 2, le dispositif de retardement (301) comprenant un filtre d'interpolation configuré pour interpoler le signal de communication échantillonné dans le domaine temporel pour obtenir le signal de communication échantillonné retardé.

**4.** Appareil (100) selon les revendications 2 ou 3, comprenant en outre :
une pondération (307) configurée pour pondérer le troisième signal de détection de phase ou le quatrième signal de détection de phase par un facteur de pondération prédéterminé.

**5.** Appareil (100) selon les revendications 2 à 4, le dispositif de détermination (107) étant configuré pour déterminer la première mesure de synchronicité ou la seconde mesure de synchronicité selon l'équation suivante :

$$CTQP = \sqrt{\overline{(A - \bar{A})^2}/\bar{B}}$$

dans laquelle CTQP désigne la première mesure de synchronicité avec A désignant le premier signal de détection de phase, B désignant le troisième signal de détection de phase, $\bar{A}$ désignant une valeur moyenne du premier signal de détection de phase, et $\bar{B}$ désignant une valeur moyenne du troisième signal de détection de phase, ou dans laquelle CTQP désigne la seconde mesure de synchronicité avec A désignant le deuxième signal de détection de phase, B désignant le quatrième signal de détection de phase, $\bar{A}$ désignant une valeur moyenne du deuxième signal de détection de phase, et $\bar{B}$ désignant une valeur moyenne du quatrième signal de détection de phase.

**6.** Appareil (100) selon les revendications 2 à 5, le dispositif de détermination (107) étant en outre configuré pour déterminer un facteur de gain de détecteur de phase sur la base du troisième signal de détection de phase ou du quatrième signal de détection de phase, le facteur de gain de détecteur de phase indiquant une amplitude du premier signal de détection de phase ou du deuxième signal de détection de phase en fonction d'une position d'un instant d'échantillonnage à l'intérieur d'un symbole de communication du premier signal de communication échantillonné filtré ou du deuxième signal de communication échantillonné filtré.

**7.** Appareil (100) selon la revendication 6, le dispositif de détermination (107) étant configuré pour déterminer le facteur de gain de détecteur de phase sur la base du troisième signal de détection de phase ou du quatrième signal de détection de phase selon l'équation suivante :

$$\mathrm{K_{pd}} = \bar{B}$$

dans laquelle, $\mathrm{K_{pd}}$ désigne le facteur de gain du détecteur de phase et $\bar{B}$ désigne une valeur moyenne du troisième signal de détection de phase ou du quatrième signal de détection de phase.

**8.** Appareil (100) selon les revendications 6 ou 7, comprenant en outre :

un filtre à boucle (309) configuré pour filtrer le premier signal de détection de phase ou le deuxième signal de détection de phase à l'aide d'une fonction de transfert de filtrage en boucle ; et
un dispositif de détermination supplémentaire (311) configuré pour déterminer la fonction de transfert de filtrage en boucle du filtre à boucle (309) sur la base du facteur de gain du détecteur de phase.

**9.** Appareil (100) selon l'une quelconque des revendications précédentes, le détecteur de phase (105) étant configuré pour déterminer le premier signal de détection de phase ou le deuxième signal de détection de phase selon l'équation suivante :

$$y(n) = abs(x(n))^k \, sign(x(n))sign(x(n + 2)) - abs(x(n + 2))^k \, sign(x(n + 2))sign(x(n))$$

dans laquelle, y désigne le premier signal de détection de phase avec x désignant le premier signal de communication échantillonné filtré, ou dans laquelle y désigne le deuxième signal de détection de phase avec x désignant le deuxième signal de communication échantillonné filtré, dans laquelle n désigne un indice d'instant d'échantillonnage, et k désigne un paramètre d'exposant prédéterminé.

**10.** Appareil (100) selon l'une quelconque des revendications précédentes comprenant en outre :
un égaliseur (315) configuré pour égaliser le signal de communication échantillonné dans le domaine temporel pour obtenir un signal de communication échantillonné égalisé.

**11.** Procédé (200) pour synchroniser un signal d'échantillonnage sur un signal de communication, le signal de communication comprenant des symboles de communication, le signal d'échantillonnage indiquant des instants d'échantillonnage du signal de communication, le procédé (200) comprenant :

l'échantillonnage (201) du signal de communication aux instants d'échantillonnage indiqués par le signal d'échantillonnage pour obtenir un signal de communication échantillonné ;

le filtrage (203) du signal de communication échantillonné à l'aide d'une première fonction de transfert de filtrage pour obtenir un premier signal de communication échantillonné filtré ; et

la détermination (205) d'un premier signal de détection de phase sur la base du premier signal de communication échantillonné filtré, le premier signal de détection de phase indiquant une position d'un instant d'échantillonnage à l'intérieur d'un symbole de communication du premier signal de communication échantillonné filtré ;

le procédé étant **caractérisé en ce qu'**il comprend en outre :

la détermination (207) d'une première mesure de synchronicité sur la base du premier signal de détection de phase, la première mesure de synchronicité indiquant une synchronicité entre le signal d'échantillonnage et le signal de communication ;

le filtrage (209) du signal de communication échantillonné à l'aide d'une seconde fonction de transfert de filtrage pour obtenir un deuxième signal de communication échantillonné filtré ;

la détermination (211) d'un deuxième signal de détection de phase sur la base du deuxième signal de communication échantillonné filtré, le deuxième signal de détection de phase indiquant une position d'un instant d'échantillonnage à l'intérieur d'un symbole de communication du deuxième signal de communication échantillonné filtré ;

la détermination (213) d'une seconde mesure de synchronicité sur la base du deuxième signal de détection de phase, la seconde mesure de synchronicité indiquant une synchronicité entre le signal d'échantillonnage et le signal de communication ; et

la sélection (215) de la première fonction de transfert de filtrage ou de la seconde fonction de transfert de filtrage pour filtrer le signal de communication échantillonné sur la base de la première mesure de synchronicité et de la seconde mesure de synchronicité pour synchroniser le signal d'échantillonnage sur le signal de communication ;

le signal d'échantillonnage étant généré sur la base du premier signal de détection de phase ou du deuxième signal de détection de phase.

**12.** Procédé (200) selon la revendication 11, comprenant en outre :

le retardement du signal de communication échantillonné dans le domaine temporel d'un retard temporel prédéterminé pour obtenir un signal de communication échantillonné retardé ;

le filtrage du signal de communication échantillonné retardé à l'aide de la première fonction de transfert de filtrage pour obtenir un troisième signal de communication échantillonné filtré ;

la détermination d'un troisième signal de détection de phase sur la base du troisième signal de communication échantillonné filtré, le troisième signal de détection de phase indiquant une position d'un instant d'échantillonnage à l'intérieur d'un symbole de communication du troisième signal de communication échantillonné filtré ;

le filtrage du signal de communication échantillonné retardé à l'aide de la seconde fonction de transfert de filtrage pour obtenir un quatrième signal de communication échantillonné filtré ; et

la détermination d'un quatrième signal de détection de phase sur la base du quatrième signal de communication échantillonné filtré, le quatrième signal de détection de phase indiquant une position d'un instant d'échantillonnage à l'intérieur d'un symbole de communication du quatrième signal de communication échantillonné filtré ;

la détermination (207) de la première mesure de synchronicité étant en outre effectuée sur la base du troisième signal de détection de phase, et la détermination (213) de la seconde mesure de synchronicité étant en outre effectuée sur la base du quatrième signal de détection de phase.

**13.** Procédé (200) selon la revendication 12, comprenant en outre :
la pondération du troisième signal de détection de phase ou du quatrième signal de détection de phase par un facteur de pondération prédéterminé.

**14.** Programme informatique comprenant un code de programme pour mettre en oeuvre le procédé (200) selon l'une quelconque des revendications 11 à 13 lorsqu'il est exécuté sur un ordinateur.

Fig. 1

Fig. 2

**Fig. 3**

Fig. 4

EP 3 158 677 B1

**Fig. 5**

Fig. 6

Fig. 7

EP 3 158 677 B1

EP 3 158 677 B1

Fig. 8

Fig. 9

EP 3 158 677 B1

Fig. 10

Fig. 11

EP 3 158 677 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8466713 B2
- US 5872818 A